**Europäisches Patentamt**

**European Patent Office**

**Office européen des brevets**

(11) Publication number: **0 348 108**

**A1**

# EUROPEAN PATENT APPLICATION

(21) Application number: **89306094.7**

(51) Int. Cl.⁴: **G01R 31/24**

(22) Date of filing: **15.06.89**

(30) Priority: **21.06.88 GB 8814663**

(43) Date of publication of application:
**27.12.89 Bulletin 89/52**

(84) Designated Contracting States:
**DE FR IT SE**

(71) Applicant: **EEV LIMITED**
**106 Waterhouse Lane**
**Chelmsford Essex CM1 2QU(GB)**

(72) Inventor: **Nicholls, Nigel S.**
**36 Worcester Road**
**Great Malvern Worcestershire(GB)**
Inventor: **Pirrie, Colin**
**12 Mews Court**
**Chelmsford Essex(GB)**

(74) Representative: **Kensett, John Hinton et al**
**GEC-Marconi Research Centre GEC-Patent**
**Department(Chelmsford Office) West**
**Hanningfield Road Great Baddow**
**Chelmsford Essex CM2 8HN(GB)**

(54) **Thyratron test circuit.**

(57) A circuit for the testing of thyratrons comprising a low voltage high average current look in parallel with a high voltage low average current loop is used by triggering the thyratron causing the high voltage capacitor C2 to be discharged via inductor L2 and load RL. The circuit fulfils the basic thyratron test in that the thyratron holds off the high voltage on capacitor C2 until it is triggered.

*FIG. 1.*

## Thyratron Test Circuit

This invention relates to a circuit for the testing of thyratrons, and in particular it relates to a circuit which can simulate the conditions normally met by a thyratron in use but utilises a considerably less amount of power.

A thyratron is a triode switching device having two electrodes interposed by a control grid electrode all electrodes being held within an envelope which is filled with a gas. The Thyratron acts as a high power switching device and is often used in systems like lasers which require high power and fast switching. Several alternative methods are currently used by the manufacturers of such devices to test them. The first approach is to use what may be termed a "total loss equivalent circuit" in which the effective average power switch by the thyratron is dissipated in a load, usually a resistive load. Since a thyratron may typically be constructed to operate with powers in range of $\frac{1}{2}$ Kw to $\frac{1}{2}$ Mw it is seen that a considerable amount of power is required to test the device using such a circuit. This can lead to a considerable expense, particularly when the average power delivered by the thyratron exceeds the 100 Kw level. The cost of components and construction costs are also prohibitive with such techniques.

As an alternative, cheater circuits have been developed for the evaluation and testing of thyratrons. The first type of these are circuits in which both the stored energy and stored charge switched per pulse by the thyratron equal those of the total loss equivalent circuit, generally within a factor of 2. Usually, the stored energy is forced to appear back in the storage capacitor at an appropriate time so that it can be applied again at the next thryratron trigger pulse.

This technique can be extremely effective and requires a lower power supply and no load. However, the component requirements are often equally demanding to those which would be required for the total loss equivalence circuit and also additional components may be required for energy recovery. All of these can be expensive. In a second type of cheater circuit, a low loss circuit is provided in which only the stored charge is close to that of the equivalent total loss circuit but in which the stored energy is much lower.

This invention arose in an attempt to improve the design of such load loss circuits.

According to the present invention there is provided a thyratron test circuit comprising, a low voltage high average current loop in parallel with a high voltage low average current loop and also in parallel with terminals for a thyratron under test.

Embodiments of the invention will now be described by way of example only with reference to the accompanying drawings in which:

Figure 1 shows a thyratron test circuit, and

Figures 2 to 6 show typical current wave forms for a varying amount of mutal inductance between the NV and LV circuits.

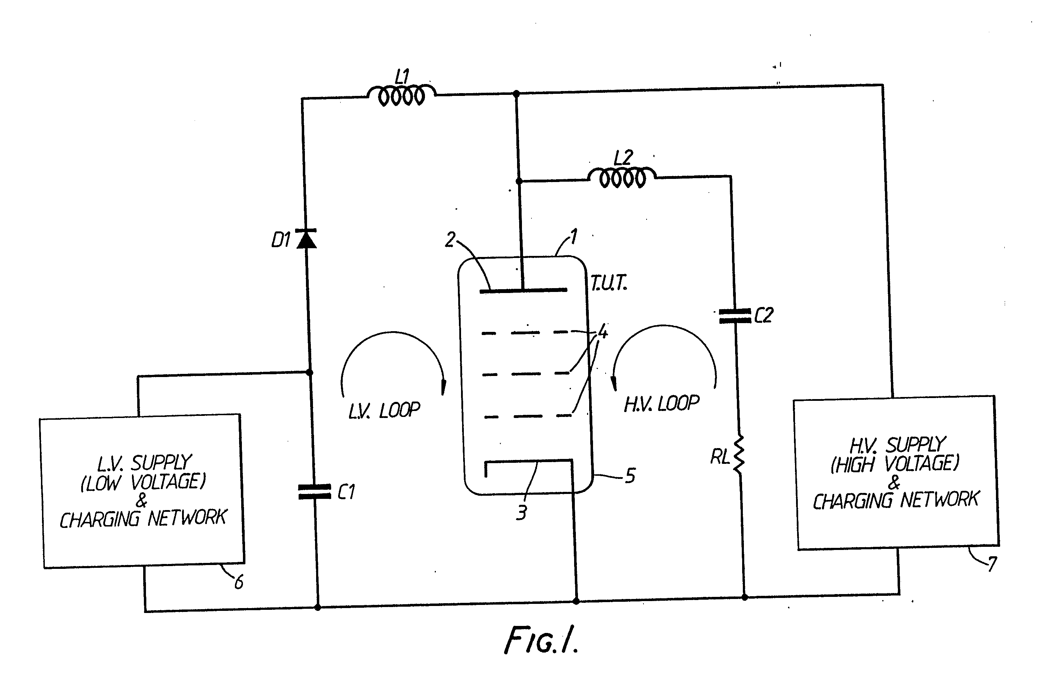

Referring to Figure 1 there is shown a circuit for the test and evaluation of a thyratron, shown as the thyratron under test (TUT) 1. The thyratron comprises an anode 2, cathode 3, and plurality of control grids 4. These are normally reversed biased and are put in a foward biased position when the thyratron is required to switch and conduct. These components are mounted within an envelope 5 which is filled with a gas such as hydrogen.

The test circuit comprises a low voltage, high average current loop, shown generally on the lefthand side of thyratron 1 and a high voltage, low average current loop, on the right-hand side of the thyratron.

The LV circuit comprises a supply and charging network 6 which is used to charge a capacitor C1 and a high voltage diode D1. An inductance L1 is shown, which is representative of the stray inductance of the discharge loop and includes the inductance associated with the diode, the capacitor and the thyratron. The high voltage network includes a high voltage supply and charging network 7 used to charge a high voltage capacitor C2 through an inductance L2 and a load RL. In use, when the tube under test 1 is triggered by setting a foward voltage on the control grid, the voltage on capacitor C1 becomes inverted as thyratron conduction proceeds. Simultaneously, high voltage capacitor C2 is discharged via inductor L2 and load RL. The energy stored in C2 is thus dissipated in the load RL and no attempt is made to recover it. The high voltage diode D1 which may for example be another thyratron or a stack of solid state diodes, serves to isolate the low voltage components from the high voltage discharge loop. After thyratron conduction ceases, the capacitors C1 and C2 re-charge from the respective LV and NV supplies 6 and 7. It is seen that the circuit fulfils the most basic of thyratron test requirements in that the thyratron holds off high voltage on capacitor C2, until it is triggered whereupon it conducts a substantial current pulse from the low voltage high current capacitor C1. Subsequent recharge voltage waveforms on the thyratron are similar to those that might appear in the equivalent total loss circuit and standard parametres such as jitter, delay time and drift may all be measured in the normal way.

An air cooled circuit has been constructed in accordance with the invention. In such a circuit, since there is no load in the LV circuit loop the power supply is only required to provide sufficient voltage to overcome inherent circuit losses. In the circuit constructed by the applicants, a variable DC supply of 0 to 300 volts was found sufficient. It should be noted that inductance L1 is the stray inductance of the discharge loop and every effort should be made to minimise L1. In the circuit constructed by the applicants, C1 was 9.4 $\mu$ F.

The average current in the low voltage loop is given by C1 Vf, where V is the total voltage swing on C1 and f the repetition rate at which the circuit is operated, ie the pulse repetition rate. The use of low loss polypropelene capacitors dictates that V = 1000 volts but operation at V = 2000 volts has been achieved. The current pulse magnitude and duration are determined by V,C1 and L1, and L1 in this example was found to be 1.3 $\mu$H. The voltage swing $\Delta$ V was found to vary from approximately + 600 volts to - 280 volts during a pulse giving the equals 880 volts. Typical values for the high voltage circuit are; C2 = 1nF, L2 = 30 $\mu$ H $R^L$ = 330 $\Omega$ and V = 35 KV. The current pulse rate of rise is inhibited in the LV loop due to the slow turn-on of the diode during the initial conduction stages. The component values of the HV loop have been chosen to produce a current pulse with approximately the same front edge rate of change for current as for the low voltage loop. The losses of the circuit and its effectiveness are strongly dependent upon the choice of C2. All of the energy stored in C2 is dissipated with a critically damped current pulse in load RL. In order that the circuit simulates the conditions which are relevant for the equivalent total loss circuit, C2 need only to be sufficiently large to provide a current pulse substantially longer than the typically 20 n s it takes for the commutative phase of the thyratron. In this way, the voltage on C2 remains essentially constant at full anode voltage during thyratron commutation. This criterion is met when C2 = 1 nF. It is thus seen that the effect of the HV current is to compensate for the inhibited rate of rise due to the diodes turn on in the LV circuit.

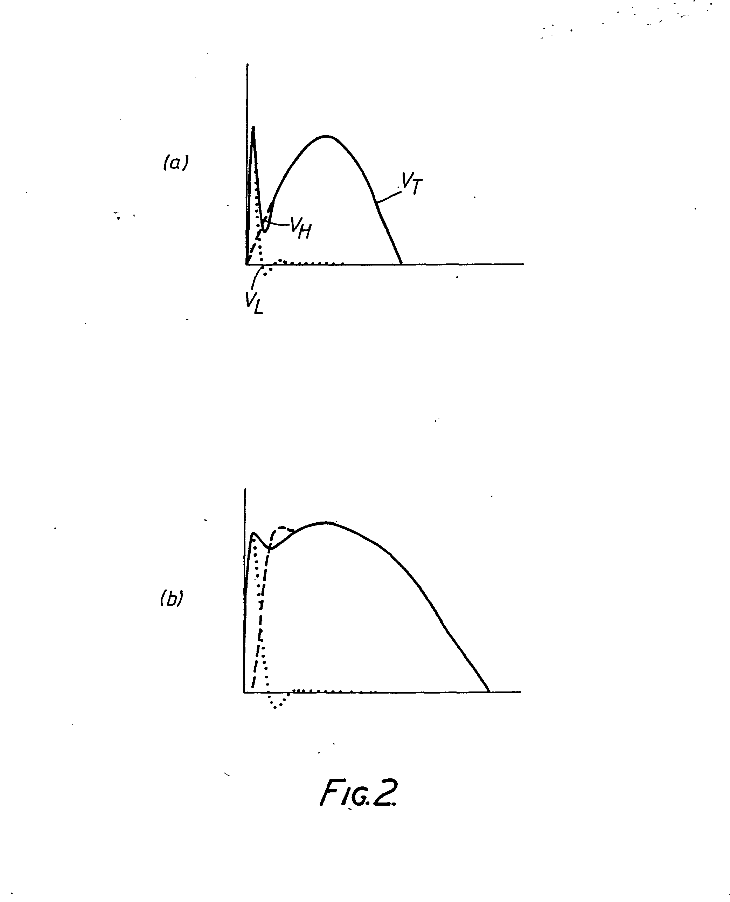

A typical pulse wave form as obtained by a circuit such as that of Figure 1 is shown in Figure 2a in which the components due to the LV loop are shown dotted as $V_L$ and the components due to the HV loop are shown in dash line VN. The resulting pulse is shown as $V_T$. Although such a pulse is useful for testing most parameters of a thyratron it is seen that it is essentially of sinusidal form. In practice, in most uses the pulse switched by a thyratron is of a more rectangular form. And thus it is useful, and in some cases necessary, to strive to obtain a more rectangular pulse with the test circuit. This may be achieved by arranging for there to be a degree of mutual inductance between the respective inductors L1 and L2 in respective LV and HV loops. It will be appreciated by the skilled man that this mutual inductance can be arranged by mechanically placing the relevant component in positions where mutual inductance occurs. It is found that depending upon the degree of mutual induction, the inductances have an effect upon each other which can change the shape of the resultant wave form. Figure 2b shows an example of how the mutal inductance can alter the pulse shape. In this figure, it is assumed that the inductance of the LV circuit is 0.5 $\mu$ H and that of the HV circuit is 5.0 $\mu$ H. The coupling factor, which is given by M / L1 where M = mutual inductance = 0.9. By gradually reducing the mutual inductance M, the pulse form reverts back to that shown in Figure 2a in which the coupling factor = 0. It is seen that by the simple expedient of mutually coupling the two inductances the pulse conducted by the thyratron may be shaped as desired, (L1 it should be remembered can just be the inductance of the elements such as the capacitor and diode in the LV loop or may be a separate inductor). The pulse of Figure 2b is a much better approximation to a rectangular pulse than that of Figure 2a.

The technique may be applied to high peak powers and average powers. Typically, longer diode chains are required, and the LV loop inductance will accordingly increase, perhaps to 2 $\mu$ H.

The HV loop may also be provided with a diode through which capacitor C2 is discharged. The action of this diode can help to drag the thyratron to a negative voltage after it has conducted the pulse, and thus helps to switch off the thyratron.

**Claims**

1. A test circuit comprising a low voltage high average current loop, (L1, D1, C1, 6) in parallel with a high voltage low average current loop (R2, C2, L2, 7) and also in parallel with terminals for a device under test (1) such that the terminals form a part of both loops and interconnect the loops.

2. A test circuit as claimed in Claim 1 wherein the device under test (1) is a thyratron.

3. A test circuit as claimed in Claim 1 or Claim 2 wherein each loop contains one or more at least partially inductive elements (L1, L2) and the inductive elements (L1, L2) are arranged in space for a chosen degree of mutual inductance.

4. A test circuit as claimed in any of the preceding claims wherein each loop includes a capacitor (C1, C2) for storing charge and subsequently discharging through the device under test (1).

Fig.I.

FIG.2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | BULLETIN ASE/UCS vol. 78, no. 9, 9 May 1987, pages 498-504; K. FROEHLICH: "Prüfung von Hochspannungsleistungsschaltern" * page 501, paragraph 6.2 "Synthetische Prüfschaltungen" - page 502, "Dreikreissynthetik" * | 1 | G 01 R 31/24 |
| Y | idem | 2-4 | |
| Y | US-A-3 460 027 (G. A. NOBLE et al.) * claim 4; figure 1 * | 2-4 | |

TECHNICAL FIELDS SEARCHED (Int. Cl.4)

G 01 R 31/24
G 01 R 31/25
G 01 R 31/32

The present search report has been drawn up for all claims

| Place of search | Date of completion of the search | Examiner |
|---|---|---|
| BERLIN | 29-08-1989 | LEMMERICH J |

EPO FORM 1503 03.82 (P0401)